# EUROPEAN PATENT SPECIFICATION

(11) **EP 3 472 825 B1**
(45) Date of publication and mention of the grant of the patent: **25.03.2026**
(21) Application number: 17736577.2
(22) Date of filing: 16.06.2017
(51) Int. Cl.: G09F 27/00, G09F 9/302

(54) **FRONT MAINTENANCE APPARATUS FOR TILED LED DISPLAY**
FRONTWARTUNGSVORRICHTUNG FÜR GEKACHELTE LED-ANZEIGE
APPAREIL D'ENTRETIEN FRONTAL POUR AFFICHAGE À DEL EN MOSAÏQUE

(30) Priority: 16.06.2016 US 201662350868 P
(43) Date of publication of application: 24.04.2019
(73) Proprietor: Barco N.V., 8500 Kortrijk (BE)
(72) Inventor: DECLERCK, Tom, B-8760 Meulebeke (BE); ADAMS, Greet, B-8540 Deerlijk (BE); DEMUYNCK, Bert, B-8870 Izegem (BE)
(74) Representative: IPLodge bv
(86) International application number: PCT/EP2017/064818
(87) International publication number: WO 2017/216366

(56) References cited:
- CN-A- 105 023 523
- CN-A- 105 023 523
- GB-A- 2 504 183
- GB-A- 2 504 183
- KR-B1- 101 452 110
- KR-B1- 101 452 110
- KR-B1- 101 452 110
- US-B2- 7 322 863
- US-B2- 7 322 863

## Description

**Background** It is known from the art how to realize emissive tiled displays and LED displays in particular that can easily be maintained. When one of the tiles must be removed for inspection, maintenance and/or be replaced, a tool is used to trigger a release mechanism. When triggered, the release mechanism allows the tile to be moved outside of the plane of the tiled display either by rotation or translation. This gives direct access to the structure behind the display tile and in particular the fastening means with which the tile is fastened to the support structure of the tiled display.

An example of release mechanism is given in US 7055271 B2 "Electronic display module having a four-point latching system for incorporation into an electronic sign and process".

The release mechanism is triggered by a tool like e.g. an Allen wrench that can be inserted through an opening in the LED panel. The opening is positioned between adjacent LEDs.

With ever increasing resolution, the space between adjacent LED decreases. There is thus less and less space available for openings through which a tool can be inserted.

With decreasing dimension, the probability that a human operator will miss the opening and apply a load on a LED increases. LEDs are usually equipped with a lens that does not support heavy loads (sometimes as little as 300 grams per LED). A tool can easily scratch the lens which will create visual artefacts not compatible with what is expected from a high-end LED display.

The art proposes solutions that do not require an opening between the LEDs. For instance, in WO2016065862 "FRONT-MAINTENANCE-TYPE LED DISPLAY MODULE AND DISPLAY SCREEN THEREOF", the tile is fastened to the support structure by means of a ferromagnetic plate. The front-maintenance-type LED display module comprises an LED lamp board and a bottom shell fixed to the LED lamp board. The bottom shell is fastened to the support structure of the tiled display.

An iron plate fixed on the bottom shell is arranged in a gap between the bottom shell and the LED lamp board. The LED lamp board and the bottom shell are positioned by using positioning columns and positioning holes, and are magnetically connected. By means of the arrangement of the iron plate, during maintenance, the LED lamp plate can be conveniently taken down from the front by using a magnetic tool, and other tools are not needed, so that the LED display module is convenient and rapid to mount. The LED board is fastened to the bottom sheet by means of magnetic pins. The magnetic tool affects the interaction between the magnetic pins and the back shell.

There are nevertheless problems with that approach:
(1) The iron plate is heavy. This is inconvenient for installation and transport.
(2) The magnetic force decreases rapidly with distance which requires bringing the magnetic tool close enough from the iron plate and the LED board. At close distance, the force increases rapidly and can surprise the human operator using it. It is not uncommon for a magnet to "fly" towards the closest ferromagnetic mass at high speed and collide with anything in between. If brought too close to the iron plate, the magnet can collide with the LED positioned between the magnet and the iron plate and damage the plastic lenses on the LED.
(3) There is nothing to hold the LED board when the magnetic pins have been disengaged. An operator having already the magnetic tool in one hand, he / she has only one hand left to prevent the tile from falling to the ground and/or scratch the LEDs on an adjacent tile.

There is a need for improvement in the art.

KR101452110B1 is considered the closest prior art. Other relevant documents are US7322863B2, GB2504183A and CN105023523A.

### Summary of the invention.

A first object of embodiments of the present invention is to provide a tiled display that can be an aesthetically pleasing seamless tiled display, and which allows removal of display tiles in a controlled manner. An advantage of embodiments of the present invention is easy access to the back of a display tile of a tiled display without having necessarily an opening in the display tile through which a tool to trigger a release mechanism would have to be inserted.

The invention relates to a front maintenance apparatus according to claim 1, a method, according to claim 14, for mounting a front access display tile using the apparatus of claim 1 and a method, according to claim 15, for removing a front access tile using the apparatus of claim 1.

This can be achieved by a method for mounting a front access display tile of a tiled display comprising display tiles located in a plane of the tiled display, a display tile having at least one cylindrical element fastened to the display tile by an intermediary of a fastener positioned at one end of the cylindrical element,- the method comprising the steps of inserting the support, fixing the cylindrical element to the tile with the fastener, activating an actuator to pull in the display tile to fit within the plane of the tiled display by activating a non-contact sensor with a dedicated non-contact device in a vicinity of the display tile until the tile slides in, the non-contact device emits a control signal received by the non-contact sensor.

This can be also achieved by a method for removing a front access display tile of a tiled display comprising display tiles located in a plane of the tiled display for maintenance or disassembling, a display tile comprising - at least one cylindrical element fastened to a display tile by an intermediary of a fastener positioned at one end of the cylindrical element, a support to support the tile when fastening or unfastening the cylindrical element, the cylindrical element and the support being able to move, e.g. slide in a direction perpendicular to the plane of the tiled display
an actuator to pull or push the cylindrical element in the direction perpendicular to the plane of the tiled display, and
a sensor to detect a control signal for controlling the position of the cylindrical element by the intermediary of the actuator,
the method comprising the steps of
- activating a non-contact sensor with a dedicated non-contact device in a vicinity of the front access display tile,
- in response to the activation of the non-contact sensor moving the display tile out of the tiled display by means of an actuator,
- releasing the fastener,
- moving the display tile out of the tiled display supported by the support.

This can also be achieved by a front maintenance apparatus for a tiled display comprising display tiles located in a plane of the tiled display, the apparatus comprising:
- at least one cylindrical element fastened to a display tile by an intermediary of a fastener positioned at one end of the cylindrical element,
- a support to support the tile when fastening or unfastening the cylindrical element, the cylindrical element and the support being able to move, e.g. slide in a direction perpendicular to the plane of the tiled display
- an actuator to pull or push the cylindrical element in the direction perpendicular to the plane of the tiled display, and
- a sensor to detect a control signal for controlling the position of the cylindrical element by the intermediary of the actuator.

This can also be achieved by a front maintenance apparatus for tiled displays comprising
- at least one cylindrical element fastened to a display tile by the intermediary of mechanical fixing means positioned at one end of the cylindrical element, a support to support the tile when fastening or unfastening the cylindrical element with mechanical fixing means, the cylindrical element and the support being able to move, e.g. slide in a direction perpendicular to the plane of the tiled display
- an actuator or motor to pull or push the cylindrical element in the direction perpendicular to the plane of the tiled display, and
- a sensor to detect a control signal for controlling the position of the

According to an example not forming part of the invention, it is provided a method of mounting a front access tile within the tiled display, the method comprising the steps of
- inserting the support in dedicated positions such as holes of the front access tool,
- attaching the tile to the support,
- fixing the cylindrical element to the tile with the mechanical fixing elements,
- activating the motor to retract the tile to fit within the plane of the tiled display by activating the non-contact sensor with the dedicated non-contact device in a vicinity of the front access tile until the tile slides in.

If the non-contact sensor is a magnetic sensor, the step of activating the non-contact sensor comprises swiping a magnet across the front access tile in the vicinity of the magnetic sensor until the tile retracts within the display and is aligned in the plane of the adjacent tiles.

According to an example not forming part of the invention, it is provided a method of removing a front access tile within the tiled display, for maintenance or disassembling, the method comprising the steps of
- activating the non-contact sensor with the dedicated non-contact device in a vicinity of the front access tile until the tile comes out of the tiled display.
- releasing the mechanical fixing elements,
- pulling the tile fixed by the support,
- releasing the screws of the adjacent tiles for maintenance or for disassembling the display.

If the non-contact sensor is a magnetic sensor, the step of activating the non-contact sensor comprises swiping a magnet across the front access tile in the vicinity of the magnetic sensor until the tile comes out of the display.

Further examples not forming part of the invention provide a front access tool or front maintenance apparatus comprising a driver cylinder for fastening to a display tile by the intermediary of a threaded driver such as a driver nut positioned at one end of the driver cylinder, a magnetic element such as a magnetic pin to support the display tile when fastening or unfastening the threaded driver such as the driver nut, the driver cylinder and the magnetic element such as the magnetic pin being able to slide in a direction perpendicular to the plane of the tiled display. An actuator such as a motor can pull or push the driver cylinder along the direction perpendicular to the plane of the tiled display. The movement of the actuator such as the motor is triggered when a sensor detects a control signal. The control signal can be generated, for example, by a human operator who wants the tile that is fastened to the front access tool to be brought out of the plane of the tiled display thereby giving access to the space behind display tiles and/or the space between display tiles and a support structure supporting the display tiles. The sensor can be a non-contact sensor. It is an advantage of the present invention that by using a non-contact sensor to trigger the motor, no opening in the display tile is required to access a release mechanism and the trigger of the motor can occur without touching the display panel, thereby avoiding to scratch it or damage it.

The threaded driver such as the driver nut can be fastened to the display tile by the intermediary of a threaded pin on the back of the display tile. The threaded driver can be a driver pin which can be fastened to the display tile by the intermediary of a threaded nut on the back of the display tile.

The magnetic elements such as magnetic pins can mate with a ferromagnetic washer on the back of the display tile. It is an advantage of the magnetic pins that they can support the display tile while the driver nuts are fastened or unfastened to the display tile. Instead of magnetic pins, washers can be used that can mate with a magnetic pin on the back of the display tile. It is an advantage of the magnetic pins and/or washers that they can support the display tile while the threaded driver such as the driver nuts are fastened to or unfastened from the display tile.

The motor can be a linear motor, for example.

In a further example not forming part of the invention, there are two and preferably four driver cylinders, each with a threaded driver such as the driver nut.

There can also be two and preferably four magnetic pins or washers.

It is an advantage of that aspect of the invention that the display tile will be better supported and more stable during maintenance operations.

In a further example not forming part of the invention, the sensor is a magnetic sensor, preferably a non-contact magnetic sensor such as a magnetic field sensor or magnetic flux density sensor. The sensor can detect varying magnetic fields like an inductive coil sensor, static magnetic fields or both. It is an advantage of that aspect of the invention that a single magnet positioned close to the display tile will trigger the mechanism that pushes the tile out of the plane of the tiled display without the need to access a release mechanism through an opening in the display tile and without the need to directly touch the tiled display.

In a further example not forming part of the invention, the sensor is positioned where the magnetic fields of the magnetic pins balance each other.

In another example not forming part of the invention, the sensor detects only varying magnetic fields or magnetic flux density fields. It is an advantage of that aspect of the invention that the sensor will not detect the field generated by the magnetic pins and the motor will not be triggered unintentionally.

In another example not forming part of the invention, a position sensor indicates if the display tile is in the same plane as the other tiles of the tiled display or if it is outside of the plane of the tiled display in a position that allows access to the fastening means fastening the display tile to the front maintenance apparatus.

The position sensor can be integrated to the actuator such as a motor.

It is an advantage of that aspect of the invention that knowing the position of the display tile can multiply the number of commands that can be conveyed by positioning a magnet in front of the display tile. For instance, if the position sensor indicates that tile is out of the plane of the tiled display, positioning the magnet in front of the display tile and the sensor can be interpreted as a request to pull the display tile back into the plane of the tiled display.

If the position sensor indicates that tile is in the plane of the tiled display, positioning the magnet in front of the display tile and the sensor can be interpreted as a request to push the display out of the plane of the tiled display.

Alternatively, a force sensor can detect a force applied to the display tile in a direction perpendicular to the plane of the display tile when it is fastened to the driver cylinder. A force sensor or a torque sensor can for instance be integrated to the actuator such as the motor.

Positioning a magnet in front of the display tile when it is in the plane of the tiled display can, for example, trigger the actuator such as the motor to push the display tile out of the plane of the tiled display.

Slightly pushing on the tile when it is out of the plane of the tiled display can, for example, trigger the motor to move, e.g. pull the display tile back into the plane of the tiled display.

No access to the back of the tiled display is required for servicing, mounting, dismounting the tiled display. Advantageously, mounting or removing tiles of the display tile according to the present invention requires no touching of the display panels, and therefore damages to the tiles are avoided.

### Brief description of the figures.

Figure 1 shows an example of tiled display according to an embodiment of this invention e.g. configured for normal use.
Figure 2A shows details of a front maintenance apparatus according to an embodiment of the present invention.
Figure 2B shows details of the fastening means for fastening a display tile to the tiled display by the intermediary of the front maintenance apparatus according to an embodiment of the present invention.
Figure 3 shows advantageous positions for some types of magnetic field sensors according to an embodiment of the present invention.
Figure 4.shows the tiled display when the front access tool has been activated and the tile 10 pushed out of the plane of the tiled display, giving access to the diver nuts according to an embodiment of the present invention.
Figure 5 shows where the tile equipped with the front access tool can be positioned in a 6X6 and a 6X8 tiled display and give access to the fastening and/or release mechanism for any of the tiles of the tiled display according to an embodiment of the present invention.
Figure 6 shows an embodiment of magnetization direction of the magnetic pins.
Figure 7A shows an embodiment wherein the linear motor 75 is coupled by coupling means 150 to a driver cylinder 74.
Figure 7B shows an embodiment wherein the driver cylinder and the motor form a single unit.
Figure 8 shows an embodiment with a display wall, power supply and data connections, management and processor electronics.
Figure 9 shows status indicators and a button for internal patterns in accordance with an embodiment of the present invention.
Figure 10 shows power cabling for use with any of the embodiments of the present invention.
Figure 11 shows a system architecture according to an embodiment of the present invention.
Figure 12 shows installing of display tiles according to an embodiment of the present invention.
Figure 13 shows installing of display tiles according to another embodiment of the present invention.

### Description of Illustrative Embodiments.

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. Where the term "comprising" is used in the present description and claims, it does not exclude other elements or steps. Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

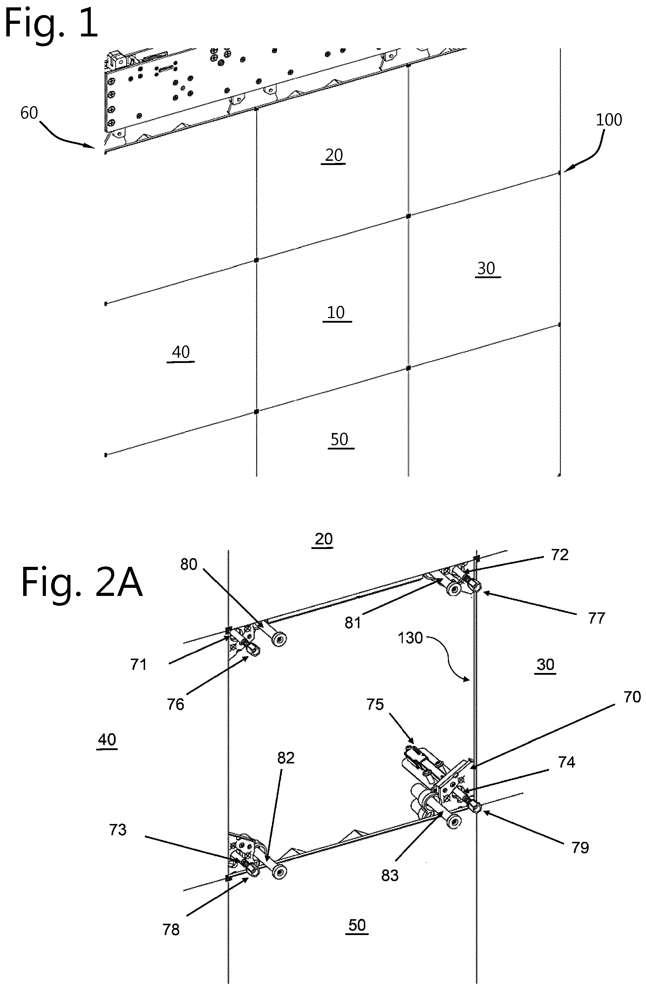

Figure 1 shows a perspective view of a tiled display 100.

Display tiles 10, 20, 30, 40, 50 ... are mounted side by side on a support structure 60. The support structure can also accommodate, for example any, some or all of cabling, power supplies, processing means etc... that provide power, data and control signals to the individual tiles 10, 20, 30, 40, 50 ...

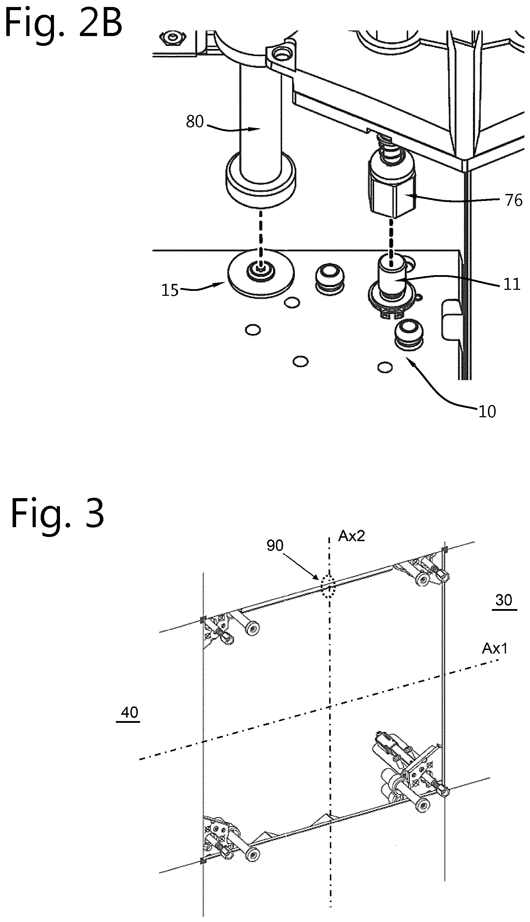

The display tiles have a front surface (which is visible on figure 1 and which emits light when the display is in use) and a back surface (not visible when the tiled display is assembled). A portion of the back surface of display tile 10 is seen on figure 2B.

The display tiles 20, 30, 40, 50 ... are fastened directly to the support structure 60 by e.g. bolts and nuts or a latching mechanism. Any means to fasten the tile to the support structure can be used as long as it can be unfastened from one side of the tile when a tile adjacent to it, like e.g. tile 10, has been removed. For instance, a latching mechanism similar to that described in US 7055271 B2 "Electronic display module having a four-point latching system for incorporation into an electronic sign and process" can be used as long as the release mechanism can be triggered once the adjacent tile has been removed.

At least one of the tiles, e.g. tile 10, is fastened to the support structure 60 by the intermediary of a front access tool or kit 70. The front access tool or kit 70 seen on figure 2A comprises at least one driver cylinder like e.g. driver cylinder 71 to support the tile 10 and fasten it to the support structure 60. Preferably, two driver cylinders 71 and 72 are used. Advantageously, four cylinders 71, 72, 73, 74 will give more stability to the tile 10 when it is pushed out of the plane of the tiled display 100. An embodiment with four driver cylinders is shown on figure 2A.

The driver cylinders are configured to move, e.g. slide back and forth in a direction perpendicular to the plane of the tiled display (the plane of the tiled display is the plane containing the tiles when they are assembled to the support structure).

At least one of the driver cylinders of the front access tool 70 has an actuator, e.g. is motorized. The actuator e.g. motor used to make the driver cylinder move, e.g. slide back and forth can be a linear motor 75. Alternatively, the motor can be a rotary motor associated to a rack and pinion mechanism, the rack being fastened to the driver cylinder. Other mechanisms like e.g. a scotch and yoke mechanism can also be used. The actuator or motor such as the motor 75 is fastened to the support structure 60.

The driver cylinders can be fastened to the tile 10. A first end of each of the driver cylinders has a driver nut (optionally another type of threaded element). The driver nut (optionally a second threaded element matching the first another type of threaded element) can be fastened to a threaded pin on the tile 10. The driver nut can e.g. rotate freely around its axis while remaining attached to the driver cylinder.

As shown on figure 2A, the driver nuts 76, 77, 78 and 79 are positioned at a first end of the driver cylinders 71, 72, 73 and 74 respectively. The driver nuts 76, 77, 78 and 79 can be fastened to threaded pins 11, 12, 13 and 14 (not shown in Figure 2a but pin 11 is shown in Figure 2B) on tile 10 respectively (the tile 10 being not shown on Figure 2A).

The term nut, driver nuts or threaded driver are used to designate the same mechanical part 76 to 79. However, it is important to bear in mind that a driver is defined in the dictionary as a mechanical piece for imparting motion to another piece and this meaning is intended to be used in the current invention.

The front access kit preferably comprises at least one magnetic pin 80 that can mate with a ferromagnetic washer 15 on the tile 10. There are preferably two or four magnetic pins. Each magnetic pin can slide back and forth in a direction perpendicular to the plane of tiled display.

The magnetic pins are used to support the tile 10 while the nuts 76, 77, 78 and 79 are fastened or unfastened from the threaded pin 11, 12, 13 and 14.

Figure 2B shows a close up of the front access tool or kit and the tile 10 as seen from behind the tiled display. One of the washers (15) and one of the threaded pins (11) can be seen as well as the corresponding magnetic pin (80) and driver nut (76).

The force exerted by the magnetic pins on the washer is preferably designed to be strong enough to keep the tile in place while the nuts 76, 77, 78 and 79 are connected to the tile. The force exerted by the magnetic pins is not necessarily strong enough to keep on carrying the weight of the tile by itself for long period of time. The force exerted by the magnetic pins is preferably not so strong that a technician would not be able to separate the magnetic pins and their corresponding washer (without using a special tool for example). For instance, the force exerted by the magnetic pins can be in the interval 1 N to 100 N in function of the dimension of the tile 10, its weight and the conditions in which the tiled display 100 has to be assembled and disassembled, used and maintained.

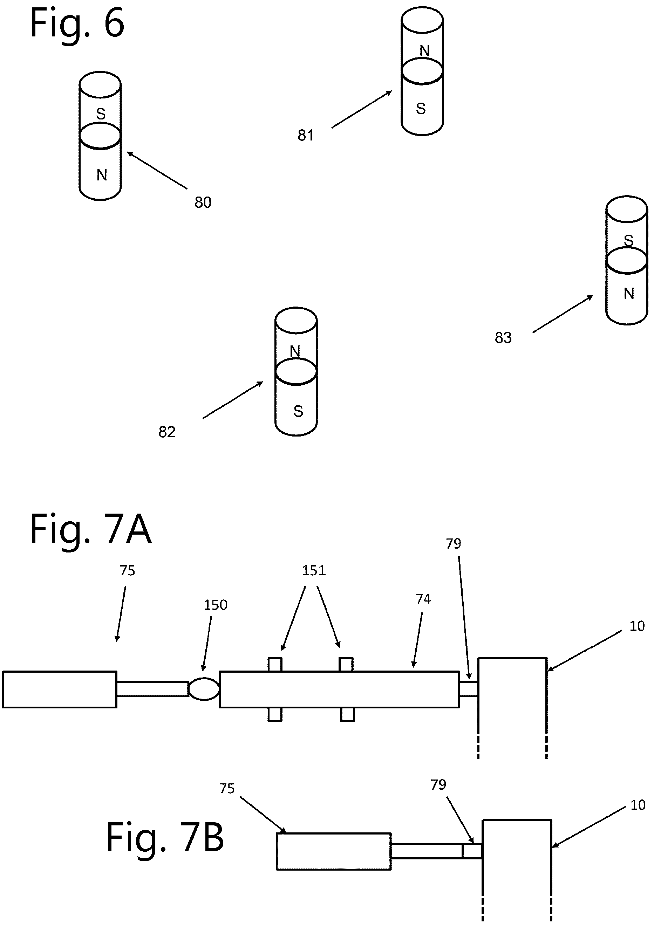

A magnetic sensor 90 is positioned on the support structure under the tile 10, as shown on Figure 3. The magnetic sensor is advantageously positioned at a position where the magnetic fields of the magnetic pins 80, 81, 82, 83 and 84 balance each other. When the magnetization of the magnetic pins is as e.g. as shown in figure 6, the sensor can for instance be positioned on one of the axis Ax1 or Ax2 seen on figure 3, located at equal distance of each pair of magnetic pins, so as to be on a symmetry axis with respect to the magnetic pins. Other geometry for the tiles and other positioning of the magnetic pins would result in different positions where the magnetic fields of the magnetic pins compensate each other, which would depend on geometrical symmetries, considering the magnetic pins have similar magnetic properties.

When a magnet 200 is brought in front of the tile 10 in the vicinity of the sensor 90 by a human operator, the actuator or motor such as the motor 75 is activated either from back to front (i.e. the driver pins will extend in front of the tiled display 100) or from front to back (i.e. the driver pins will be pulled towards the tiled display 100) depending on its original position.

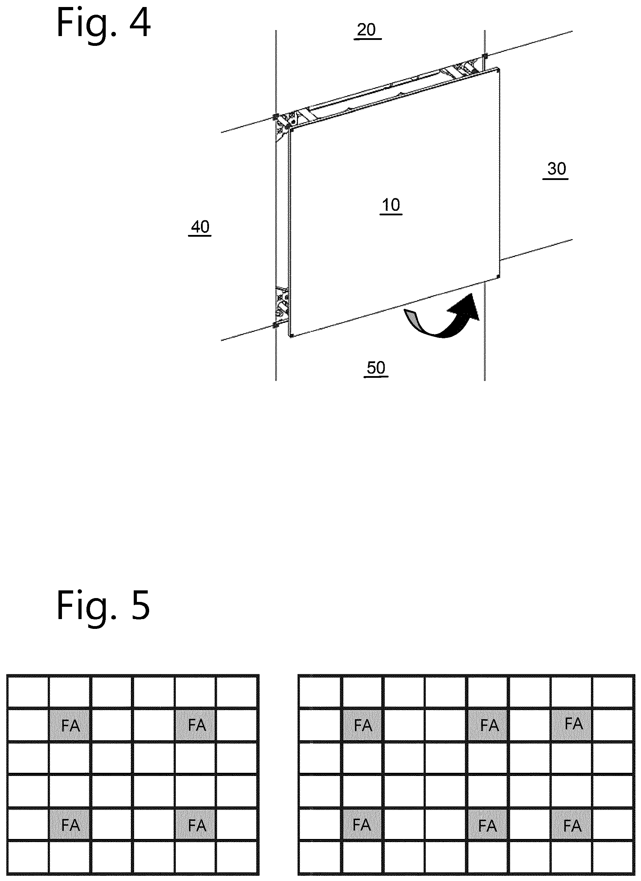

If the tile 10 is coplanar with tiles 20, 30, 40, 50 ... as shown on figure 1; then when the sensor 90 detects the magnetic field of magnet 200; the motor 75 will push tile 10 out of the plane of the display and give access to the driver nuts 76, 77, 78 and 79. The situation is then as on figure 4.

A human operator can then unfasten the threaded elements such as the driver nuts from the corresponding pin on tile 10. Tile 10 is kept in place by the magnetic pins 80, 81, 82, 83.

Once all the threaded elements such as the driver nuts have been unfastened, the human operator can take the tile 10 away from the tiled display.

Once the tile 10 is away, the space 130 between tiles 20, 30, 40, 50 and the support structure is accessible, as shown in figure 2a. A tool can for instance be used to e.g. trigger a release mechanism that will unfasten the desired tile 20, 30, 40, 50 from the support structure 60. The tile can then be grasped and taken away (e.g. to disassemble the tiled display or to take a defect tile to maintenance).

Once tile 20, 30, 40 or 50 is taken away, access to the space 130 between the support structure and yet another tile is possible.

Figure 5 shows an example of a 6 by 6 tile and 8 by 6 tile displays with possible positions for the front access tool FA. Advantageously, each tile 10 comprising a front access tool is surrounded by six other tiles without a front access tool and two tiles 10 comprising a front access tool are separated by one or two tiles without a front access tool. With this positioning of the front access tool, it is possible to access any tile of the tiled display by removing a single of the tile positioned on one of the front access tool.

The magnetic sensor 90 can e.g. be a reed relay, a magneto resistor, a Hall sensor or an induction coil (with or without ferromagnetic core). The magnetic sensor can sense either the magnetic field or as is more often the case the magnetic field density.

In the case of an induction coil sensor, only variation in the magnetic field or magnetic field density will be detected. The speed at which these variations should occur will depend on the coil geometry (in particular the number of turn and the cross section of the coil), the nature of the core and the electronics that processes the signal generated by the sensor.

The advantage of a sensor such as an induction coil is that slow variations due to e.g. asymmetrical thermal expansion of the support structure will have no effect. Similarly, such a sensor will not be sensitive to static or DC differences in the magnetic characteristics of the magnetic pins 80, 81, 82, 83 and 84. With such a sensor, it is not necessary to position the sensor where the magnetic fields of the magnetic pins and the motor(s) 75 balance each other or at least compensate each other as much as possible (i.e. the position where the resulting magnetic field will be less than at other positions).

When DC sensors are used (e.g. a Hall sensor or magneto-resistor), a high pass filter can be used to isolate the system from static and slowly varying magnetic fields.

The magnetic field or magnetic flux density sensor 90 can for instance be a digital Output Hall-Effect Switch comprising a Schmitt-trigger threshold detector with built-in hysteresis. When the applied magnetic flux density exceeds a certain limit, the trigger provides a clean transition from off to on without contact bounce. Built-in hysteresis eliminates oscillation (spurious switching of the output) by introducing a magnetic dead zone in which switch action is disabled after the threshold value is passed.

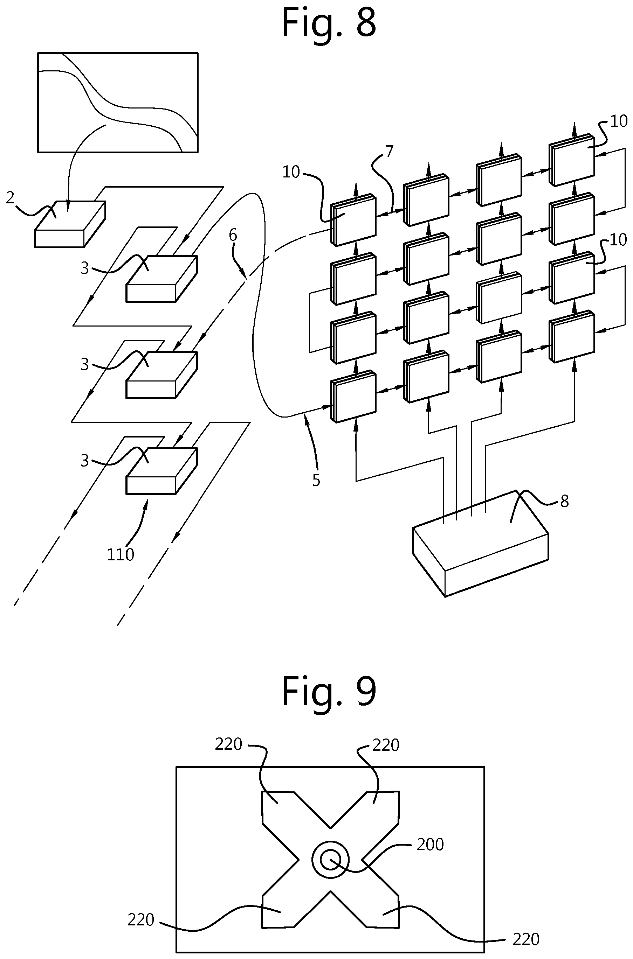

The signal of the Hall-Effect switch is fed to e.g. a microprocessor system 110 as described with reference to in Fig. 8.

The microprocessor system 110 uses the signal of the Hall-Effect switch to control the position of the driver cylinder. If the actuator or motor such as the motor 75 comprises a position sensor 120, the microprocessor 110 can determine the action expected by the human operator: if the position of the actuator e.g. motor as detected by the position sensor 120 is such that the driver cylinders are extended in front of the tiled display 100, triggering the Hall-Effect switch may be interpreted as a signal to pull the driver cylinders back (to e.g. bring tile 10 in the plane of the tiled display).

If the position of the actuator, e.g. motor as detected by the position sensor is such that the driver cylinders are behind the plane of the display tiles, triggering the Hall-Effect switch may be interpreted as a signal to push the driver cylinders forward (to e.g. bring tile 10 out the plane of the tiled display and give access to the driver nuts).

Alternatively, the microprocessor can keep track of the last command it issued (e.g. by storing in volatile or non-volatile memory) to the actuator or motor such as the linear motor 75 and issue the opposite command whenever the Hall-Effect switch is triggered.

Alternatively, triggering the Hall-effect switch produces a single action: pushing the driver cylinders. If the linear motor 75 is equipped with a torque sensor (the torque applied to the motor when a force is applied along the direction of the driver cylinder), pushing on the tile 10 when it is fastened to the driver nuts and driver cylinders may trigger a signal that the microprocessor interprets as a request to pull the driver cylinders back.

In another embodiment according to the present invention, illustrated on Figure 7, the driver cylinder and the motor form a single unit. In some cases, each of the driver cylinders can be the shaft of a motor 75 as seen on figure 7B.

The advantage of driver cylinders like 79 is that they can take up the torque caused by the weight of the tile 10. In normal use, the weight of the tile is vertical while the motor and its shaft are horizontal. Linear motors are not necessarily able to take a lateral load (i.e. a force perpendicular to the shaft of the linear motor as seen on figure 7A).

In those cases, the linear motor 75 is coupled by coupling means 150 to a driver cylinder 74. The driver cylinder 74 slides in bores 151 which are fastened to or part of the support structure 60 (not shown). The bore will bear the weight of the tile 10 in the gravity field (g) 160 and the motor is not subjected to a lateral force.

Several alternatives are possible in function of the particular sensor used, the availability of other sensors like a position sensor and a force sensor.

Other non-contact sensors are possible including but not limited to capacitive sensors, microphones (sound sensors or ultra sound sensors), etc.

In another embodiment of the present invention, the motor can be provided with a Bluetooth or with a NFC receiver. This receiver enables the front access tiles to be operated by means of a dedicated application from a portable device such as a tablet, a smartphone or a computer, or a dedicated remote control so as to be able to operate the tiled display remotely. The dedicated application can further allow the user to visualize a representation of the tiled display such that, by selecting the desired front access tile, it would activate the motor.

While the description was made for LED display tiles, the invention also applies to other types of emissive display tiles like fixed format displays e.g. liquid crystal displays, OLED displays, reflective displays like electrophoretic displays.

The present invention also pertains to a method for mounting a front access display tile of a tiled display comprising display tiles located in a plane of the tiled display, a display tile having at least one cylindrical element fastened to the display tile by an intermediary of a fastener positioned at one end of the cylindrical element,- the method comprising the steps of
inserting the support,
fixing the cylindrical element to the tile with the fastener,
activating an actuator to pull in the display tile to fit within the plane of the tiled display by activating a non-contact sensor with a dedicated non-contact device in a vicinity of the display tile until the tile slides in, the non-contact device emits a control signal received by the non-contact sensor.

The tile can thus be fixed to the structure while being supported by the support.

The present invention also pertains to a method for removing a front access display tile of a tiled display comprising display tiles located in a plane of the tiled display for maintenance or disassembling, a display tile comprising - at least one cylindrical element fastened to a display tile by an intermediary of a fastener positioned at one end of the cylindrical element,
a support to support the tile when fastening or unfastening the cylindrical element, the cylindrical element and the support being able to move, e.g. slide in a direction perpendicular to the plane of the tiled display
an actuator to pull or push the cylindrical element in the direction perpendicular to the plane of the tiled display, and
a sensor to detect a control signal for controlling the position of the cylindrical element by the intermediary of the actuator,
the method comprising the steps of
   - activating a non-contact sensor with a dedicated non-contact device in a vicinity of the front access display tile,
   - in response to the activation of the non-contact sensor moving the display tile out of the tiled display by means of an actuator,
   - releasing the fastener,
   - moving the display tile out of the tiled display supported by the support.
   - If the non-contact sensor is a magnetic sensor, the step of activating the non-contact sensor comprises the step of swiping a magnet across the front access tile in the vicinity of the magnetic sensor until the tile retracts within the display and is aligned in the plane of the adjacent tiles.

A tiled display system in accordance with embodiments of the present invention comprises for example a plurality of display tiles 10, which can be fixed format display tiles such as LED or OLED tiles, a truss or base stand, a power supply 8, manager electronics 2 and processor electronics 3 as shown in Fig. 8. A web based client interface 1 can be provided and the manager electronics 2 can provide with display management hardware. For example, the display management hardware e.g. with software can provide the web interface 1 that allows users to access information in the display hardware and can offer tools to view and manipulate settings on the hardware.

The processor electronics 3 can include one or more display processor(s) 110 as well as inputs for receiving data from one or more data sources. A plurality of display tiles can be provided. The data path 5 to the tiles can be provided by one or more connections such as fibre optic cables or other means of communication such as one or more cables, e.g. Unshielded Twisted Pair (UTP) Cable, Shielded Twisted Pair (STP) Cable, Coaxial Cable or one or more wireless connections. Connections 7 can also be provided between tiles, e.g. connections to data ports one the tiles to provide a data between two tiles, such connections can be fibre optic cables or other means of communication such as one or more cables, e.g. Unshielded Twisted Pair (UTP) Cable, Shielded Twisted Pair (STP) Cable, Coaxial Cable or one or more wireless connections.

The design can optionally include redundancy such as more connections 6 than are actually needed. The redundancy feature helps to automatically correct a data interruption due to a missing link in the data cabling, for example. All tiles behind the interruption will receive their content via the redundancy data line 6. Hence, the complete displayed image can be restored quickly.

As previously described with reference to Figs. 1 to 7, each corner of a tile can be provided with pins and studs that precisely fit the separate connection plates used to connect to the surrounding tiles. This allows alignment and fastening of the tile into a display wall such as a fixed format wall e.g. an LED or OLED wall.

One or more, e.g. four tile status indicators 220 can be provided on each tile, e.g. on a side (see Fig. 9). The one or more status indicators can be, for example LED's or OLED's. Being located on the side of a tile allows to see the data signal direction of each tile (either in normal or in redundancy mode). Means 200 can be provided such as a button (see Fig. 9) which can be used to generate internal patterns for display on the tile without requiring an external signal. The status indicators can be arranged to indicate whether the means for generating internal patterns has been activated, if there is no data input, if the data input is OK, etc.

For a truss setup truss beams 202 of the support structure 60 are used to set up a display wall in a hanging configuration. Each truss beam 202 can be equipped with two or more lifting eyes. To build such a display wall, the tiles can be connected mechanically using connection pieces.

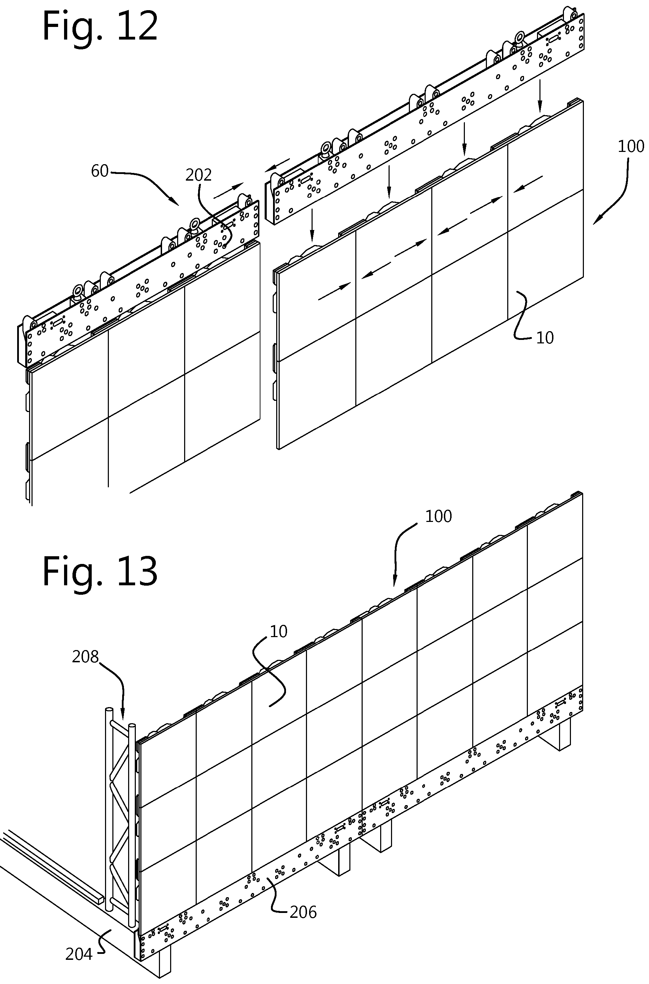

To construct a base stand setup of a display wall in a base stand configuration mounting accessories as well as foot beams 204, truss/floor beams 206 and stackers 208 can be used (see Fig. 13). The plurality of tiles are built upon the truss/floor beams 206. Foot beams 204 provide an interface between the truss/floor beams 206 and the floor.

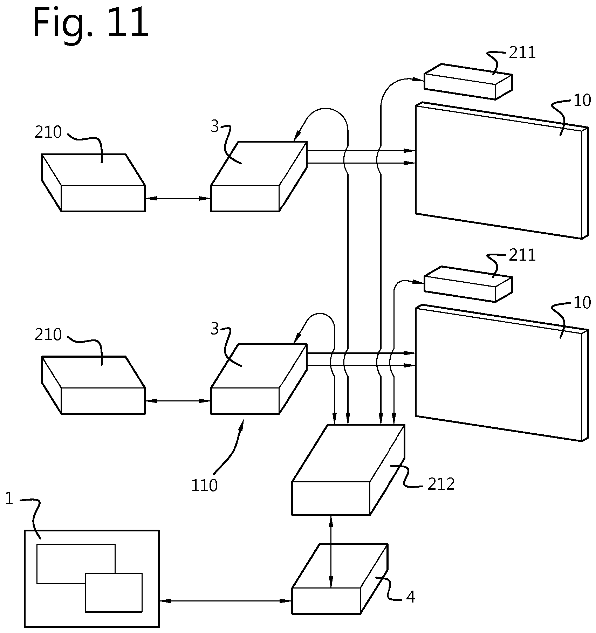

Devices on such as system (see Fig. 11) can include:
· (a) One or more video source(s) 210
· (b) Client interface 1: via a web browser running on a processing device such as laptop or desktop computer. The customer device can be connected to a network such as LAN via connection on the manager electronics.

· (c) One or more display processor(s) 3, e.g. for processing and retransmitting connected video source(s) and the managing of the connected display tiles and modules. The display processors can include a microprocessor 110.
· (d) Display Management Hardware 4 providing a web interface into the system.
· (e) Modular display(s) with tiles 10
· (f) Ambient Environment Controller 211 (optional)
· (g) Optional Ethernet switch 212. Instead of a switch two control ports which can be used to loop the device control connection.

Connections between the tiles can include:
· Video source connection
· Client device connection
· Device control connection
· Display connection

### Setup process

The first stage in the process is the installation of the truss/floor beam on the truss installation. Multiple truss/floor beams can be joined together if needed.

The second stage in the process is attaching a first row of display tiles with the truss/floor beams to form one solid row.

The truss connection pieces can be installed either in the center position or front position of the tile suspension points.

Correct the position of the truss lifting eyes to match the center of gravity (fully to the front for front installation or centered for centered installation).

For each truss/floor beam separately, place several display tile(s) next to each other on a clean floor.

Using connection pieces, connect the top and bottom corners of the tiles and then attach the truss/floor beam to the top of the tiles.

Lift the truss/floor beam with the display tiles and join the tiles of the neighboring truss/floor beam.

The next stage is the installation of the remaining display tiles one by one and row by row.

After installing two rows of tiles, the data and power connections can be made before lifting the rows further up. These rows are now accessible from the work floor.

The power and data cabling of the display tiles can now be completed.

There are preferably several, such as seven, connection ports on the back of each display tile. For example, two can be power sockets such as one input and one output for daisy chaining the tiles. Several such as four bidirectional data ports can be provided, for example two data ports at the left side and two data ports at the right side. A serial port such as a USB port for service purposes can also be provided.

The data ports can be configured to automatically detect an incoming signal on one of the two dual port sockets. The other dual socket can be configured to automatically act as an output port. Data linking cables can be configured to provide a dual data path from tile to tile in a daisy chain manner.

When a data cable between two tiles is removed or seriously damaged so that the data link is interrupted, all next tiles in the string will lose their data link if the tiles are daisy chained. To prevent this, a redundancy loop can be created. If a redundancy loop is created then the last tile will detect that there is data available on the other side (input from the redundant cable) and will change direction. All other tiles will change their direction too so that video signal is supplied from the last tile up to the tile that had the failure. The correct image is restored.

Note that the setup of a redundancy loop is optional.

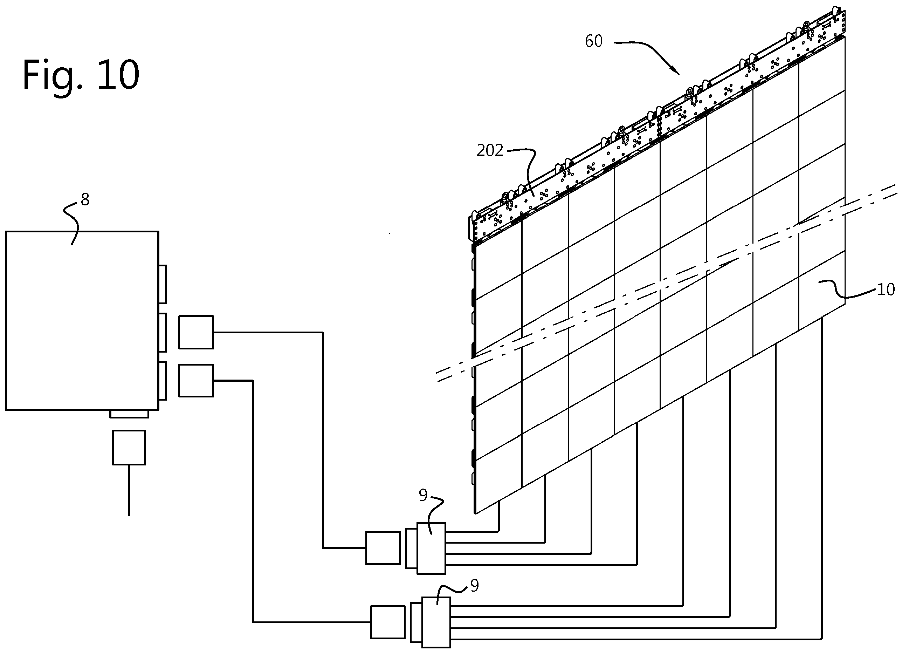

A power supply system is shown in Fig. 10. The power box 8 can be connected via cables and spider connectors 9 to each column of display tiles.

## Claims

1. A front maintenance apparatus (70) for a tiled display (100) comprising display tiles (10, 20, 30, 40, 50) located in a plane of the tiled display, the apparatus comprising:
- at least one cylindrical element (71) fastened to a display tile (10) by an intermediary of a fastener (76) positioned at one end of the cylindrical element (71),
- a support (80) to support the tile (10) when fastening or unfastening the cylindrical element (71), the cylindrical element (71) and the support (80) being able to move relative to the plane of the tiled display and slide in a direction perpendicular to the plane of the tiled display an actuator (75) to pull or push the cylindrical element (71) in the direction perpendicular to the plane of the tiled display, and **characterized by** the apparatus comprising:
∘ a non-contact sensor (90); wherein the non-contact sensor (90) is configured to detect a control signal for controlling the position of the cylindrical element (7) by the intermediary of said actuator (75), wherein a non-contact device (200) is configured to generate the control signal in the vicinity of the display tile (10, 20, 30, 40, 50).

2. A front maintenance apparatus (70) according to claim 1, wherein the at least one cylindrical element (71) is a driver cylinder and the fastener (76) is a threaded driver.

3. A front maintenance apparatus (70) according to claim 2, wherein the driver cylinder and the actuator (75) form a single unit and in particular each of the driver cylinders is the shaft of a motor.

4. A front maintenance apparatus (70) according to any previous claim, wherein the support (80) comprises two or four magnetic pins.

5. The front maintenance apparatus (70) according to any previous claim, wherein the dedicated non-contact device (200) comprises a magnet and the non-contact sensor (90) is a magnetic sensor to detect when the magnet is positioned or swiped in front of the tiled display (100) in the vicinity of the sensor (90).

6. The front maintenance apparatus (70) according to claim 5, wherein the magnetic sensor only detects variations in a magnetic field or magnetic field density.

7. The front maintenance apparatus (70) according to claim 4 and claim 5, wherein the magnetic sensor detects a static magnetic field or magnetic field density, wherein the magnetic fields of the two or four magnetic pins balance each other out in at least one position in the vicinity of the display tiles (10, 20, 30, 40, 50) and wherein the sensor is positioned in this at least one position.

8. The front maintenance apparatus (70) according to any previous claim, wherein the actuator (75):
comprises a position sensor (120), or
comprises a force sensor for sensing a force applied to a display tile (10) in a direction perpendicular to a surface of the display tile (10) when the tile is fastened to a driver cylinder.

9. The front maintenance apparatus (70) according to any previous claim, the apparatus (70) comprising two or four driver cylinder elements.

10. The front maintenance apparatus (70) according to claim 9, wherein the driver cylinder elements are provided in the vicinity of the corners of a tile (10), or the magnetic pins are provided in the vicinity of the corners of the tile (10).

11. A display tile (10) comprising a front maintenance apparatus (70) according to any previous claim, wherein the display tile is any of a LED display tile, a liquid crystal displays, OLED displays, or a reflective display such as electrophoretic displays.

12. A tiled display (100) comprising at least one tile (10) with a front maintenance apparatus (70) according to any of the claims 1 to 10.

13. A tiled display (100) according to claim 12, wherein each display tile (10) comprising a front maintenance apparatus (70) is surrounded by six tiles without a front maintenance apparatus (70), and two tiles comprising a front maintenance apparatus (70) are separated by one or two tiles with no front maintenance apparatus (70).

14. A method for mounting a front access display tile (10) of a tiled display (100) comprising display tiles (10, 20, 30, 40, 50) located in a plane of the tiled display using the front maintenance apparatus (70) according to any of claims 1-10, the method comprising the steps of
- inserting the support (80) to support the tile (10) when fastening the cylindrical element (71),
- fixing the cylindrical element (71) to the tile (10) with the fastener (76),
- activating an actuator (75) to pull in the display tile (10) to fit within the plane of the tiled display by activating the non-contact sensor (90) with the dedicated non-contact device (200) in a vicinity of the display tile (10) until the tile slides in.

15. A method for removing a front access display tile (10) of a tiled display (100) comprising display tiles (10, 20, 30, 40, 50) located in a plane of the tiled display for maintenance or disassembling using the front maintenance apparatus (70) according to any of claims 1-10,
the method comprising the steps of
- activating the non-contact sensor (90) with the dedicated non-contact device (200) in a vicinity of the front access display tile (10),
- in response to the activation of the non-contact sensor (90) moving the display tile (10) out of the tiled display (100) by means of an actuator (75),
- releasing the fastener (76),
- moving the display tile (10) out of the tiled display (100) supported by the support (80).

## Patentansprüche

1. Frontwartungsvorrichtung (70) für eine Kachelanzeige (100), die Anzeigekacheln (10, 20, 30, 40, 50) umfasst, die sich in einer Ebene der Kachelanzeige befinden, wobei die Einrichtung Folgendes umfasst:
- mindestens ein zylindrisches Element (71), das an einer Anzeigekachel (10) über ein Befestigungselement (76) befestigt ist, das an einem Ende des zylindrischen Elements (71) positioniert ist,
- einen Träger (80) zum Tragen der Kachel (10) beim Befestigen oder Lösen des zylindrischen Elements (71), wobei das zylindrische Element (71) und der Träger (80) dazu in der Lage sind, sich relativ zu der Ebene der Kachelanzeige zu bewegen und in einer Richtung senkrecht zu der Ebene der Kachelanzeige zu gleiten,
- einen Aktuator (75) zum Ziehen oder Schieben des zylindrischen Elements (71) in der Richtung senkrecht zu der Ebene der Kachelanzeige und **dadurch gekennzeichnet, dass** die Einrichtung Folgendes umfasst:
• einen kontaktfreien Sensor (90); wobei der kontaktfreie Sensor (90) dazu konfiguriert ist, ein Steuersignal zum Steuern der Position des zylindrischen Elements (7) über den Aktuator (75) zu erfassen, wobei eine kontaktfreie Vorrichtung (200) dazu konfiguriert ist, das Steuersignal in der Nähe der Anzeigekachel (10, 20, 30, 40, 50) zu erzeugen.

2. Frontwartungseinrichtung (70) nach Anspruch 1, wobei das mindestens eine zylindrische Element (71) ein Antriebszylinder ist, und das Befestigungselement (76) ein Gewindeantrieb ist.

3. Frontwartungseinrichtung (70) nach Anspruch 2, wobei der Antriebszylinder und der Aktuator (75) eine einzige Einheit bilden und insbesondere jeder der Antriebszylinder die Welle eines Motors ist.

4. Frontwartungseinrichtung (70) nach einem vorstehenden Anspruch, wobei der Träger (80) zwei oder vier Magnetstifte umfasst.

5. Frontwartungseinrichtung (70) nach einem vorstehenden Anspruch, wobei die dedizierte kontaktfreie Vorrichtung (200) einen Magnet umfasst und der kontaktfreie Sensor (90) ein Magnetsensor ist, um zu erfassen, wenn der Magnet vor der Kachelanzeige (100) in der Nähe des Sensors (90) positioniert ist oder gewischt wird.

6. Frontwartungseinrichtung (70) nach Anspruch 5, wobei der Magnetsensor nur Variationen in einem Magnetfeld in einer Magnetfelddichte erfasst.

7. Frontwartungseinrichtung (70) nach Anspruch 4 und Anspruch 5, wobei der Magnetsensor ein statisches Magnetfeld oder Magnetfelddichte erfasst, wobei die Magnetfelder der zwei oder vier Magnetstifte einander in mindestens einer Position in der Nähe der Anzeigekacheln (10, 20, 30, 40, 50) ausgleichen, und wobei der Sensor in dieser mindestens einen Position positioniert ist.

8. Frontwartungseinrichtung (70) nach einem vorstehenden Anspruch, wobei der Aktuator (75):
einen Positionssensor (120) umfasst, oder
einen Kraftsensor zum Abtasten einer Kraft umfasst, die an einer Anzeigekachel (10) in einer Richtung senkrecht zu einer Oberfläche der Anzeigekachel (10) angelegt wird, wenn die Kachel an einem Antriebszylinder befestigt ist.

9. Frontwartungseinrichtung (70) nach einem vorstehenden Anspruch, wobei der Träger (70) zwei oder vier Antriebszylinderelemente umfasst.

10. Frontwartungseinrichtung (70) nach Anspruch 9, wobei die Antriebszylinderelemente in der Nähe der Ecken einer Kachel (10) bereitgestellt sind, oder wobei die Magnetstifte in der Nähe der Ecken der Kachel (10) bereitgestellt sind.

11. Anzeigekachel (10), die eine Frontwartungseinrichtung (70) nach einem vorstehenden Anspruch umfasst, wobei die Anzeigekachel eine beliebige von LED-Anzeigekachel, Flüssigkristallanzeigen, OLED-Anzeigen oder einer reflektierenden Anzeige wie einer elektrophoretischen Anzeige ist.

12. Kachelanzeige (100), die mindestens eine Kachel (10) mit einer Frontwartungseinrichtung (70) nach einem der Ansprüche 1 bis 10 umfasst.

13. Kachelanzeige (100) nach Anspruch 12, wobei jede Anzeigekachel (10), die eine Frontwartungseinrichtung (70) umfasst, von sechs Kacheln ohne eine Frontwartungseinrichtung (70) umgeben ist, und zwei Kacheln, die eine Frontwartungseinrichtung (70) umfassen, durch eine oder zwei Kacheln ohne Frontwartungseinrichtung (70) getrennt sind.

14. Verfahren zum Montieren einer Frontzugangsanzeigekachel (10) einer Kachelanzeige (100), die Anzeigekacheln (10, 20, 30, 40, 50) umfasst, die sich in einer Ebene der Kachelanzeige befinden, unter Verwendung der Frontwartungseinrichtung (70) nach einem der Ansprüche 1-10, wobei das Verfahren die Schritte umfasst zum
- Einsetzen der Träger (80) zum Tragen der Kachel (10) beim Befestigen des zylindrischen Elements (71),
- Befestigen des zylindrischen Elements (71) an der Kachel (10) mit dem Befestigungselement (76),
- Aktivieren eines Aktuators (75) zum Ziehen in der Anzeigekachel (10), um in die Ebene der Kachelanzeige zu passen, durch Aktivieren des kontaktfreien Sensors (90) mit der dedizierten kontaktfreien Vorrichtung (200) in einer Nähe der Anzeigekachel (10), bis die Kachel hereingleitet.

15. Verfahren zum Entfernen einer Frontzugangsanzeigekachel (10) einer Kachelanzeige (100), die Anzeigekacheln (10, 20, 30, 40, 50) umfasst, die sich in einer Ebene der Kachelanzeige befinden, zur Wartung oder zum Abbauen unter Verwendung der Frontwartungseinrichtung (70) nach einem der Ansprüche 1-10,
wobei das Verfahren die Schritte umfasst zum
- Aktivieren des kontaktfreien Sensors (90) mit der dedizierten kontaktfreien Vorrichtung (200) in einer Nähe der Frontzugangsanzeigekachel (10),
- als Reaktion auf die Aktivierung des kontaktfreien Sensors (90) Herausbewegen der Anzeigekachel (10) aus der Kachelanzeige (100) mittels eines Aktuators (75),
- der das Befestigungselement (76) löst,
- Herausbewegen der Anzeigekachel (10) aus der Kachelanzeige (100) getragen von dem Träger (80).

## Revendications

1. Appareil de maintenance frontale (70) pour un afficheur en mosaïque (100) comprenant des dalles d'affichage (10, 20, 30, 40, 50) situées dans un plan de l'afficheur en mosaïque, l'appareil comprenant :
- au moins un élément cylindrique (71) fixé à une dalle d'affichage (10) par l'intermédiaire d'un dispositif de fixation (76) positionné au niveau d'une extrémité de l'élément cylindrique (71),
- un support (80) pour supporter la dalle (10) lors de la fixation ou du détachement de l'élément cylindrique (71), l'élément cylindrique (71) et le support (80) étant susceptibles de se déplacer par rapport au plan de l'afficheur en mosaïque et de coulisser dans une direction perpendiculaire au plan de l'afficheur en mosaïque,
- un actionneur (75) pour tirer ou pousser l'élément cylindrique (71) dans la direction perpendiculaire au plan de l'afficheur en mosaïque, et **caractérisé en ce que** l'appareil comprend :
∘ un capteur sans contact (90), dans lequel le capteur sans contact (90) est configuré pour détecter un signal de commande pour commander la position de l'élément cylindrique (71) par l'intermédiaire dudit actionneur (75), dans lequel un dispositif sans contact (200) est configuré pour produire le signal de commande au voisinage de la dalle d'affichage (10, 20, 30, 40, 50).

2. Appareil de maintenance frontale (70) selon la revendication 1, dans lequel l'au moins un élément cylindrique (71) est un cylindre d'entraînement et le dispositif de fixation (76) est un entraîneur fileté.

3. Appareil de maintenance frontale (70) selon la revendication 2, dans lequel le cylindre d'entraînement et l'actionneur (75) forment une unité unique et en particulier chacun des cylindres d'entraînement est l'arbre d'un moteur.

4. Appareil de maintenance frontale (70) selon l'une quelconque des revendications précédentes, dans lequel le support (80) comprend deux ou quatre broches magnétiques.

5. Appareil de maintenance frontale (70) selon l'une quelconque des revendications précédentes, dans lequel le dispositif sans contact dédié (200) comprend un aimant et le capteur sans contact (90) est un capteur magnétique pour détecter lorsque l'aimant est positionné ou glissé devant l'afficheur en mosaïque (100) au voisinage du capteur (90).

6. Appareil de maintenance frontale (70) selon la revendication 5, dans lequel le capteur magnétique détecte seulement des variations dans un champ magnétique ou une densité de champ magnétique.

7. Appareil de maintenance frontale (70) selon la revendication 4 et la revendication 5, dans lequel le capteur magnétique détecte un champ magnétique statique ou une densité de champ magnétique, dans lequel les champs magnétiques des deux ou quatre broches magnétiques s'équilibrent mutuellement dans au moins une position au voisinage des dalles d'affichage (10, 20, 30, 40, 50) et dans lequel le capteur est positionné dans cette au moins une position.

8. Appareil de maintenance frontale (70) selon l'une quelconque des revendications précédentes, dans lequel l'actionneur (75) :
comprend un capteur de position (120), ou
comprend un capteur de force pour détecter une force appliquée à une dalle d'affichage (10) dans une direction perpendiculaire à une surface de la dalle d'affichage (10) lorsque la dalle est fixée à un cylindre d'entraînement.

9. Appareil de maintenance frontale (70) selon l'une quelconque des revendications précédentes, l'appareil (70) comprenant deux ou quatre éléments de cylindre d'entraînement.

10. Appareil de maintenance frontale (70) selon la revendication 9, dans lequel les éléments de cylindre d'entraînement sont disposés au voisinage des angles d'une dalle (10), ou les broches magnétiques sont disposées au voisinage des angles de la dalle (10).

11. Dalle d'affichage (10) comprenant un appareil de maintenance frontale (70) selon l'une quelconque des revendications précédentes, dans laquelle la dalle d'affichage est l'une quelconque d'une dalle d'affichage à LED, d'afficheurs à cristaux liquides, d'afficheurs OLED, ou d'un afficheur réflectif tel que des afficheurs électrophorétiques.

12. Afficheur en mosaïque (100) comprenant au moins une dalle (10) avec un appareil de maintenance frontale (70) selon l'une quelconque des revendications 1 à 10.

13. Afficheur en mosaïque (100) selon la revendication 12, dans lequel chaque dalle d'affichage (10) comprenant un appareil de maintenance frontale (70) est entourée par six dalles sans appareil de maintenance frontale (70), et deux dalles comprenant un appareil de maintenance frontale (70) sont séparées par une ou deux dalles sans appareil de maintenance frontale (70) .

14. Procédé pour monter une dalle d'affichage à accès frontal (10) d'un afficheur en mosaïque (100) comprenant des dalles d'affichage (10, 20, 30, 40, 50) situées dans un plan de l'afficheur en mosaïque en utilisant l'appareil de maintenance frontale (70) selon l'une quelconque des revendications 1 à 10, le procédé comprenant les étapes consistant à
- insérer le support (80) pour supporter la dalle (10) lors de la fixation de l'élément cylindrique (71),
- fixer l'élément cylindrique (71) à la dalle (10) avec le dispositif de fixation (76),
- activer un actionneur (75) pour tirer la dalle d'affichage (10) afin de l'ajuster à l'intérieur du plan de l'afficheur en mosaïque en activant le capteur sans contact (90) avec le dispositif sans contact dédié (200) au voisinage de la dalle d'affichage (10) jusqu'à ce que la dalle coulisse à l'intérieur.

15. Procédé pour retirer une dalle d'affichage à accès frontal (10) d'un afficheur en mosaïque (100) comprenant des dalles d'affichage (10, 20, 30, 40, 50) situées dans un plan de l'afficheur en mosaïque pour maintenance ou démontage en utilisant l'appareil de maintenance frontale (70) selon l'une quelconque des revendications 1 à 10,
le procédé comprenant les étapes consistant à
- activer le capteur sans contact (90) avec le dispositif sans contact dédié (200) au voisinage de la dalle d'affichage à accès frontal (10),
- en réponse à l'activation du capteur sans contact (90), déplacer la dalle d'affichage (10) hors de l'afficheur en mosaïque (100) au moyen d'un actionneur (75),
- libérer le dispositif de fixation (76),
- déplacer la dalle d'affichage (10) hors de l'afficheur en mosaïque (100) supportée par le support (80).
